# EUROPEAN PATENT APPLICATION

(11) **EP 1 596 432 A1**
(43) Date of publication of application: **16.11.2005**
(21) Application number: 05009851.6
(22) Date of filing: 04.05.2005
(51) Int. Cl.: H01L 21/762

(54) **Semiconductor device and manufacturing method thereof**

(30) Priority: 11.05.2004 JP 2004141584
(71) Applicant: SONY CORPORATION, Tokyo (JP)
(72) Inventor: Nagaoka, Kohjiro Sony Corp., Tokyo (JP)
(74) Representative: Müller - Hoffmann & Partner

(57) **Abstract**

In order to improve embeddability of an embedded insulating film to a filling portion to have a preferable embedded structure, the present invention provides a semiconductor device having an embedded structure in which an embedded insulating film is embedded in a filling portion formed in or on a substrate. The embedded structure includes an underlying insulating film containing a silicon nitride film formed on an inner wall of the filling portion by a chemical vapor deposition method using material gas containing hexachlorodisilane, and an embedded insulating film formed by filling in the filling portion via the underlying insulating film.

## Description

### CROSS REFERENCES TO RELATED APPLICATIONS

The present document contains subject matter related to Japanese Patent Application JP 2004-141584 filed in the Japanese Patent Office on May 11, 2004, the entire contents of which being incorporated herein by reference.

### BACKGROUND OF THE INVENTION

### 1. Field of the Invention

The present invention relates to a semiconductor device and a manufacturing method thereof, such as a semiconductor device having an embedded structure in which an embedded insulating film is embedded within a trench formed in a semiconductor substrate, and a manufacturing method thereof.

### 2. Description of Related Art

As technique of electrically isolating elements formed on a semiconductor substrate, shallow trench isolation structure (hereinafter referred to as "STI structure") is known, in which a trench is formed in a semiconductor substrate and an insulating film is filled therein. This is disclosed in, for example, Japanese Patent Application Publication No. 2002-289683.

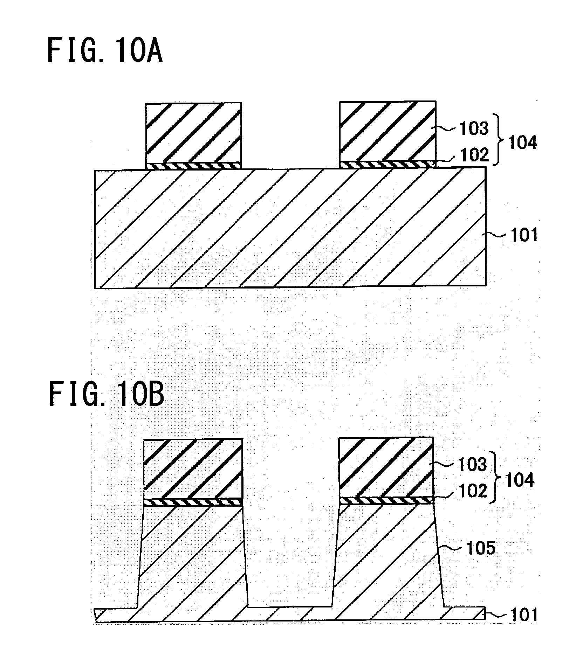

FIGs. 10A to 12C are sectional views showing an example of producing a STI structure of a related art. Referring now to FIG. 10A, a mask pattern 104 for forming a trench, composed of a silicon thermal oxide film 102 and a silicon nitride film 103 is formed on a semiconductor substrate such as a silicon substrate (hereinafter referred to simply as a substrate) 101.

Referring to FIG. 10B, by the use of the mask pattern 104, the substrate 101 is dry-etched to form a trench (groove) 105 at a region for element isolation.

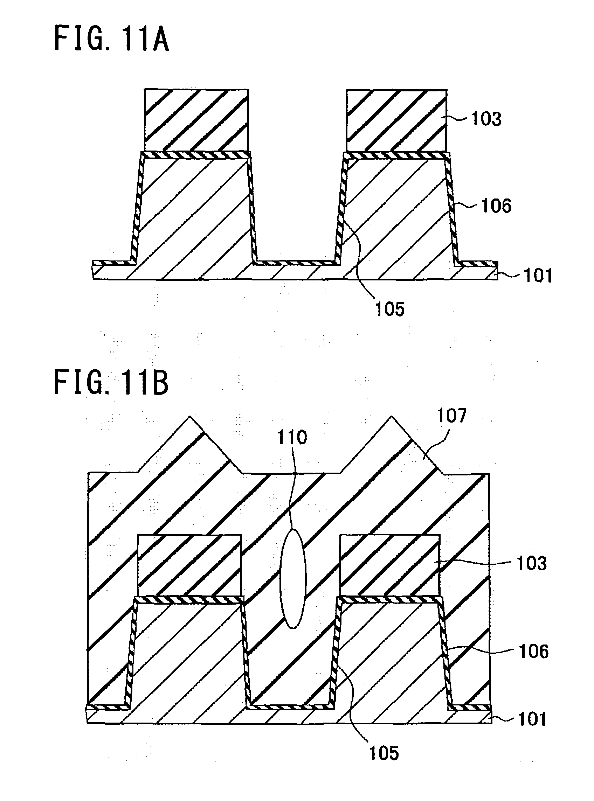

Referring to FIG. 11A, a silicon thermal oxide film 106 is formed on an inner wall of the trench 105 by thermal oxidation method. Referring to FIG. 11B, an embedded insulating film 107 is formed by depositing a silicon oxide film so that the interior of the trench 105 is completely filled. It is noted that an insulating film embedded in a trench or the like to fill the trench is referred to as "embedded insulating film" in the present specification.

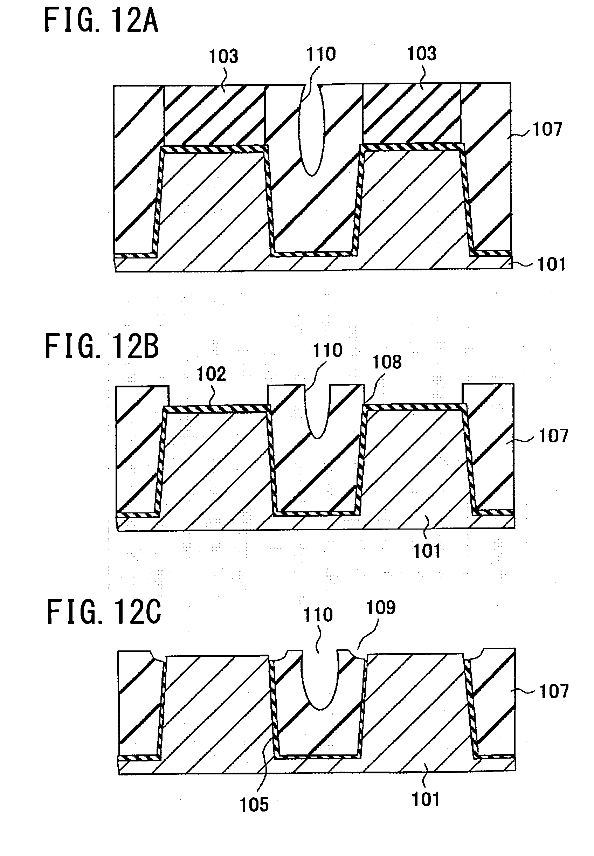

Referring to FIG. 12A, any excessive embedded insulating film 107 is subjected to chemical mechanical polishing (CMP) with the silicon nitride film 103 as stopper. Referring to FIG. 12B, the silicon nitride film 103 is then removed by wet etching.

Finally, referring to FIG. 12C, the silicon thermal oxide film 102 and part of the embedded insulating film 107 are removed by wet etching. At this time, the embedded insulating film 107 is etched such that the surface height of the embedded insulating film 107 is slightly higher than that of the substrate 101.

Since the wet etching in the step shown in FIG. 12C is isotropic, the etching is best advanced from an intersection 108 at which the side surface of the embedded insulating film 107 and the upper surface of the silicon thermal oxide film 102 are intersected (see FIG. 12B). Therefore, as shown in FIG. 12C, a recess 109 may be formed at an upper peripheral edge of the embedded insulating film 107. Such a recess 109 has a depth of approximately 30 nm.

Thus, the STI structure having the trench 105 filled with the embedded insulating film 107 can be completed by the foregoing procedure.

### SUMMARY OF THE INVENTION

As LSI elements have been miniaturized in recent years, element isolation width, wiring width, and the like have been not more than 100 nm. It has become increasingly more difficult to fill a filling portion composed of a recess, such as between elements, between wiring layers, and between electrodes, with an insulating film such that sufficient electrical isolation resistance is attainable without causing any void and seam. It is noted that a portion to be filled with an insulating material is referred to as "filling portion" in the present specification.

For example, when filling in a trench for element isolation, a high density plasma (HDP) CVD method has been employed in related arts in order to fill a silicon oxide film in the trench for attaining element isolation.

However, when the width of the trench 105 is as narrow as not more than 100 nm, the embeddability of the HDP-CVD may arise a problem that a void 110 occurs as shown in FIG. 11B, and the void 110 remains within the trench 105 as shown in FIG. 12C, and a gate electrode material to be produced in the succeeding step will be left in the void 110 and can cause failure such as short circuit between gates.

Thus, there is a desire for an embedded structure and a method of forming the same, with which it is capable of preventing the occurrence of void and seam, and also ensuring sufficient electrical isolation resistance, when a filling portion such as a trench of a substrate surface portion formed for element isolation, or a recess between wiring layers or between electrodes, is filled with an insulator.

The present invention was made in view of the aforementioned problem and in consideration of a need for providing a semiconductor device that has an embedded structure offering good embeddability of an embedded insulating film to a filling portion, and that can ensure electrical isolation resistance by the presence of the embedded insulating film.

The present invention also takes into account a need of providing a method of manufacturing a semiconductor device, with which it is capable of improving embeddability of an embedded insulating film to a filling portion, and forming a good embedded structure.

In one embodiment of the present invention, there is provided a semiconductor device having an embedded structure in which an embedded insulating film is embedded in a filling portion formed in or on a substrate. The embedded structure has an underlying insulating film containing a silicon nitride film formed on an inner wall of the filling portion by a chemical vapor deposition method using material gas containing hexachlorodisilane, and an embedded insulating film formed by filling in the filling portion via the underlying insulating film.

In this semiconductor device, a surface condition having good embeddability of the embedded insulting film is attainable by the underlying insulating film that is formed on the inner wall of the filling portion, and that contains the silicon nitride film formed by chemical vapor deposition method using the material gas containing hexachlorodisilane. The filling portion is filled with the embedded insulating film via the underlying insulting film. Since the semiconductor device of the invention has the embedded structure having good embeddability of the embedded insulting film to the filling portion, it is possible to ensure electrical isolation resistance with the embedded insulating film.

In another embodiment of the present invention, there is provided a method of manufacturing a semiconductor device including the step of forming an embedded structure by embedding an embedded insulating film within a filling portion formed in or on a substrate. This method includes the step of forming on an inner wall of the filling portion an underlying insulating film containing a silicon nitride film by chemical vapor deposition method using a material gas containing hexachlorodisilane; and the step of forming an embedded insulating film so as to fill in the filling portion via the underlying insulating film.

In this method, the underlying insulating film containing the silicon nitride film is first formed on the inner wall of the filling portion by the chemical vapor deposition method using the material gas containing hexachlorodisilane. This underlying insulating film produces a surface condition having good embeddability of the embedded insulating film. The filling portion can be filled well with the embedded insulating film by filling the filling portion with the embedded insulating film via the underlying insulating film. Therefore, this method enables to improve the embeddability of the embedded insulating film to the filling portion, thereby forming a good embedded structure.

### BRIEF DESCRIPTION OF THE DRAWINGS

FIG. 1 is a sectional view showing a main part of an embedded structure in the semiconductor device according to a first embodiment of the present invention;

FIGs. 2A to 6B are sectional views showing manufacturing steps of a semiconductor device of the first embodiment;

FIG. 7 is a sectional view showing a main part of an embedded structure in a semiconductor device according to a second embodiment of the present invention;

FIGs. 8A to 9C are sectional views showing manufacturing steps of the semiconductor device of the second embodiment; and

FIGs. 10A to 12C are sectional views showing manufacturing steps of a semiconductor device according to a related art.

### DETAILED DESCRIPTION OF PREFERRED EMBODIMENTS

Preferred embodiments of a semiconductor device and its manufacturing method of the present invention will now be described with reference to the accompanying drawings. In the following embodiments, a description will be given of a case of embedding an insulating film within a trench formed in a substrate, among a trench on a substrate surface portion that is formed for element isolation, or filling portions such as recesses between wiring layers and between electrodes.

### [First Embodiment]

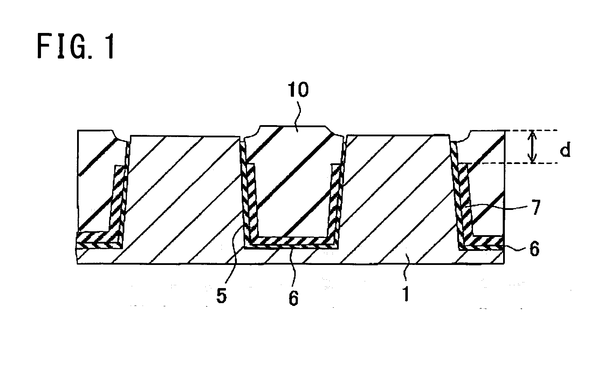

FIG. 1 is a sectional view showing a main part of an embedded structure in a semiconductor device according to a first preferred embodiment.

In the semiconductor device of FIG. 1, a trench (filling portion) 5 is formed at an element isolation region of a semiconductor substrate such as of silicon (hereinafter referred to simply as a substrate) 1. On the inner wall of the trench 5, a silicon thermal oxide film 6 is formed, and a silicon nitride film (underlying insulating film) 7 is also formed.

The silicon nitride film 7 is a silicon nitride film formed by the chemical vapor deposition method using material gas containing hexachlorodisilane (HCD) Si₂C1₆ (hereinafter referred to as HCD-silicon nitride film). The HCD-silicon nitride film 7 is disposed for producing surface condition to accelerate the growth rate of a silicon oxide film to be embedded within the trench 5.

The film thickness of the HCD-silicon nitride film 7 is preferably in a range of 0.5 nm to 50 nm, for example. The purpose of setting to not less than 0.5 nm is to obtain a surface condition having superiority in accelerating the growth rate of the silicon oxide film. The purpose of setting to not more than 50 nm is to avoid that a film thickness exceeding 50 nm will fill up the trench 5. Further, the end portion of the HCD-silicon nitride film 7 is preferably apart from the surface of the substrate 1 by a distance d of not more than 100 nm.

An embedded insulating film 10 composed of a silicon oxide film is formed within the trench 5 via the HCD-silicon nitride film 7. The silicon oxide film that becomes the embedded insulating film 10 is formed by a sub-atmospheric chemical vapor deposition (SACVD) method.

The embedded insulating film 10 embedded within the trench 5 constitutes an element isolation insulating film, and an element such as a transistor, though it is not shown, is formed at an active region of the substrate 1 surrounded by the element isolation insulating film.

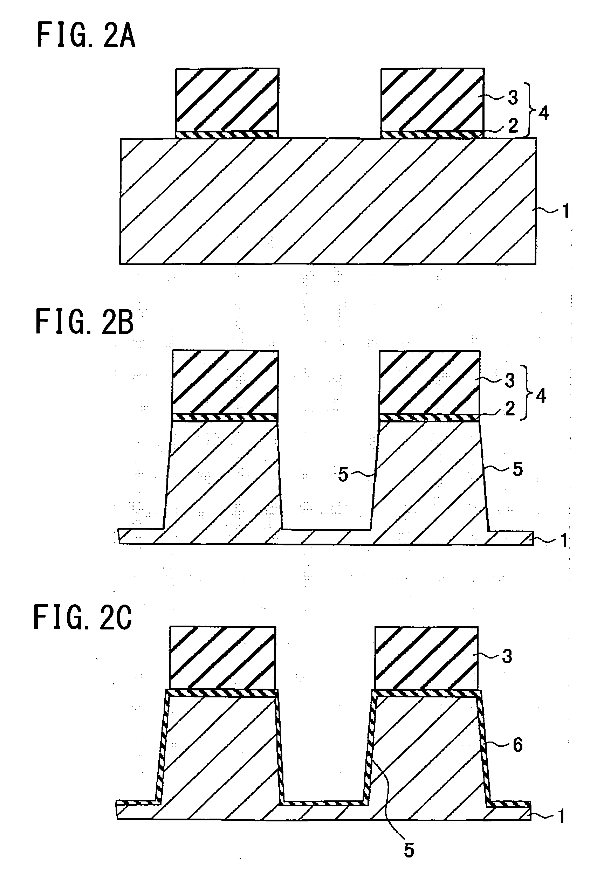

A method of manufacturing a semiconductor device according to the first preferred embodiment will next be described with reference to FIGs. 2A to 6B.

Referring now to FIG. 2A, on a semiconductor substrate composed of silicon or the like (hereinafter referred to simply as substrate) 1, a silicon thermal oxide film 2 is formed by the thermal oxidation method, and a silicon nitride film 3 is formed by the CVD method. The CVD for forming the silicon nitride film 3 employs, for example, dichlorosilane (DCS) SiH₂C1₂ as a material gas. Subsequently, a resist pattern is formed on the silicon nitride film 3. With the resist pattern as a mask, the silicon nitride film 3 and the silicon thermal oxide film 2 are etched to form a mask pattern 4 composed of the silicon thermal oxide film 2 and the silicon nitride film 3. The resist pattern is then removed.

Referring to FIG. 2B, with the mask pattern 4 as the mask, the substrate 1 is processed by dry etching, such as reactive ion etching (RIE), thereby forming a trench 5.

Referring to FIG. 2C, a silicon thermal oxide film 6 is formed by the thermal oxidation method, on the inner wall of the trench 5 formed in the substrate 1. The purpose of the silicon thermal oxide film 6 is to compensate for damage on the substrate surface, resulting from the etching for forming the trench 5, and also prevent the occurrence of dislocation within the substrate 1 by rounding the corners of the trench 5 so as to relax stress.

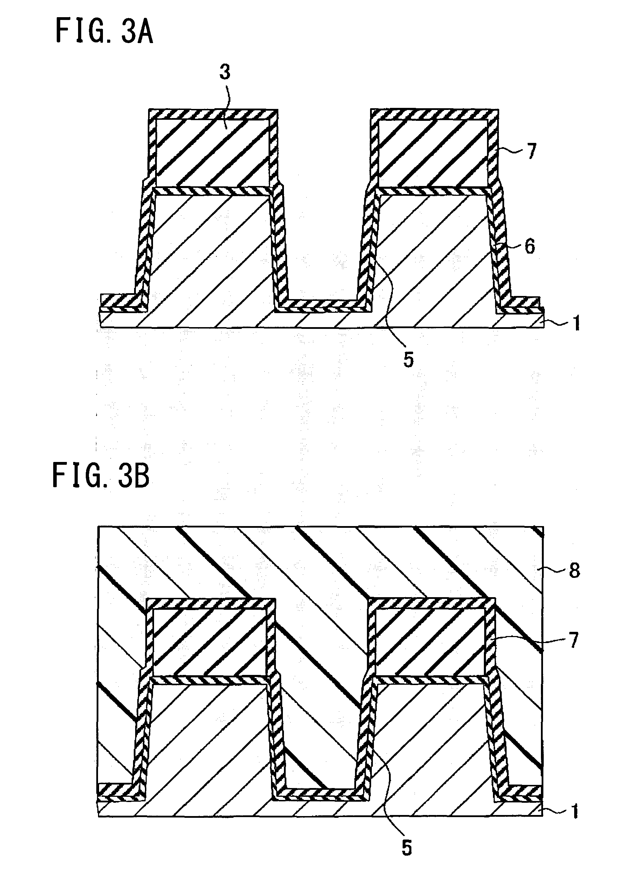

Referring to FIG. 3A, by CVD method using mixed gas of Si₂C1₆ and NH₃, an HCD-silicon nitride film 7 is formed on the entire surface covering the inner wall of the trench 5 and the silicon nitride film 3. The film forming temperature of the HCD-silicon nitride film 7 is set between 380°C and 600°C. For example, the film forming conditions of the HCD-silicon nitride film 7 is set at 1.0 Torr (133.3 Pa) in film forming pressure, 500°C in film forming temperature, 20 sccm in fluid flow of Si₂C1₆, and 350 sccm in fluid flow of NH₃.

Referring to FIG. 3B, by applying a resist, a resist film 8 is formed on the HCD-silicon nitride film 7 so as to fill up the trench 5.

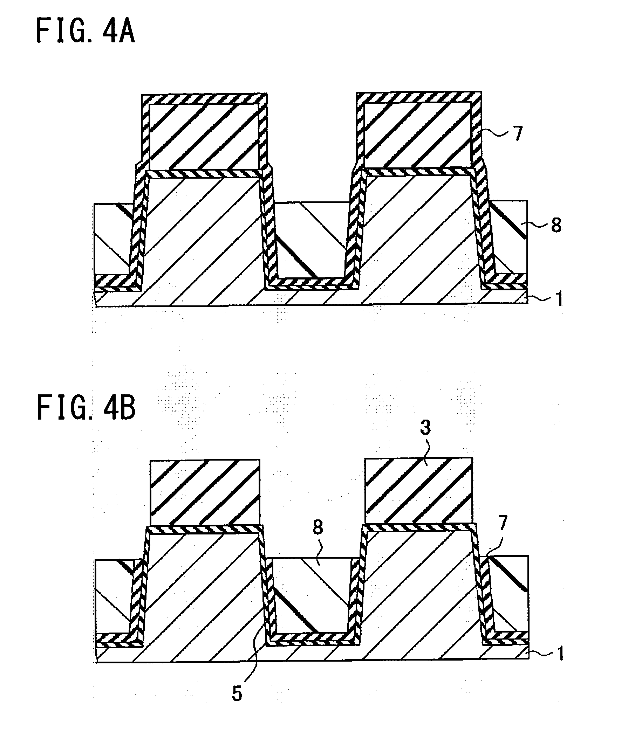

Referring to FIG. 4A, the resist film 8 is dry-etched to leave the resist film 8 only within the trench 5. At this time, the surface of the resist film 8 is preferably apart from the surface of the substrate 1 by not more than 100 nm.

Referring to FIG. 4B, portions of the HCD-silicon nitride film 7 which are exposed from the resist film 8 are removed by hot phosphoric acid treatment. Instead of the hot phosphoric acid treatment, diluted hydrofluoric acid treatment may be used to strip the HCD-silicon nitride film 7. No limitation is imposed on the way of stripping. Referring to FIG. 5A, the resist film 8 remaining in the trench 5 is then removed.

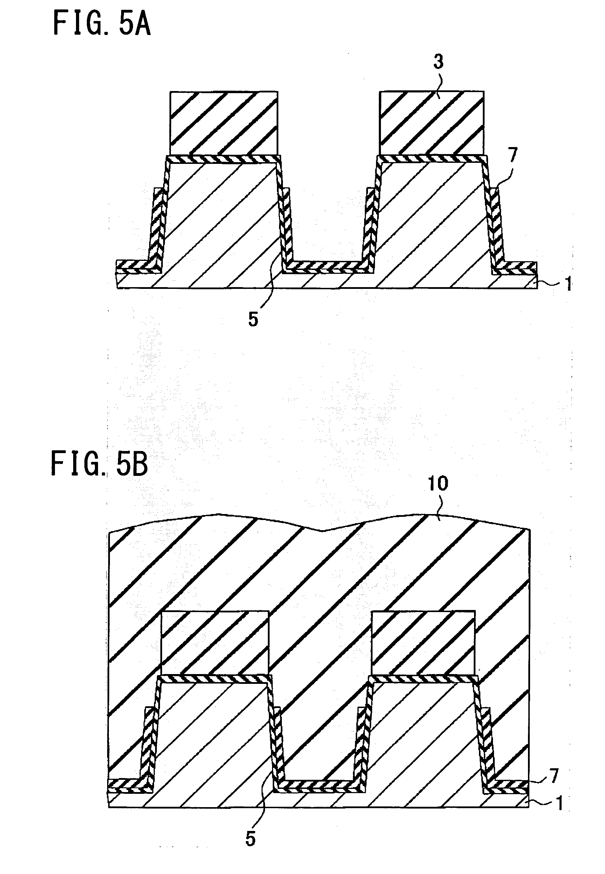

Referring to FIG. 5B, an embedded insulating film 10 is formed by depositing a silicon oxide film SiO₂ so as to fill up the trench 5 by the sub-atmospheric CVD method. At this time, the CVD conditions are, for example, 540°C in film forming temperature, and 600 Torr (80.0 kPa) in film forming pressure. As the material gas, tetraethylorthosilicate (TEOS) and ozone O₃ are used. For example, the material gas is allowed to flow at 17 liter/min, and the rate of ozone in the material gas is 12.5% by weight.

The CVD for forming the embedded insulating film 10 is preferably the sub-atmospheric CVD method, but it may be the atmospheric CVD method. In the present specification, the sub-atmospheric pressure is, for example, not less than 100 Torr (13.3 kPa) and not more than the atmospheric pressure (760 Torr = 101.3 kPa).

The sub-atmospheric CVD is highly dependent on an underlying. For instance, when a silicon nitride film, which is the same as the silicon nitride film 3 and uses, as the material gas, dichlorosilane (hereinafter referred to as DCS-silicon nitride film), is employed as underlying insulating film, the embeddability of the silicon oxide film is poor, and void will be generated when the trench 5 has a narrow width.

Since in the first preferred embodiment, the HCD-silicon nitride film 7 is formed on the inner wall of the trench 5 as the underlying insulating film, it is a surface condition different from in the DCS-silicon nitride film. Compared to the case of using the DCS-silicon nitride film, the underlayer-dependency of the sub-atmospheric CVD is reduced, and the rate of film forming of the silicon oxide film within the trench 5 is improved and the film quality is also improved. In the first preferred embodiment, good embeddability free of void in the trench 5 is attainable by forming the silicon oxide film by the sub-atmospheric CVD, after forming the HCD-silicon nitride film 7 as the underlying insulating film.

After forming the embedded insulating film 10, annealing, for example, at 850°C for 30 minutes, is performed to make denser the embedded insulating film 10. This annealing atmosphere is preferably oxygen atmosphere (e.g., H₂O or O₂). Alternatively, the rapid thermal anneal (RTA) method may be employed.

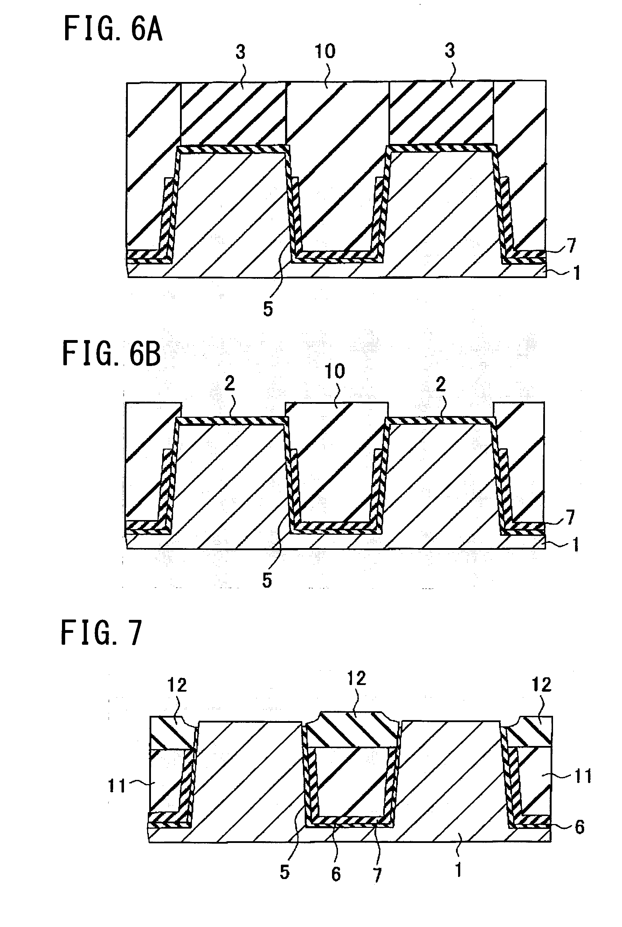

Referring to FIG. 6A, with the silicon nitride film 3 as a stopper, any excessive embedded insulating film 10 is subjected to chemical mechanical polishing (CMP) in order to planarize the surface of the embedded insulating film 10.

Referring to FIG. 6B, the silicon nitride film 3 is removed by diluted hydrofluoric acid treatment and then hot phosphoric acid treatment.

Finally, the silicon thermal oxide film 2 is removed by wet etching. This results in the embedded structure shown in FIG. 1. The semiconductor device can be manufactured through the succeeding steps of: forming a gate electrode and the like at an active region of the substrate 1; forming impurity regions that become source or drain by ion implantation; forming an interlayer insulating film; and forming wiring.

In the method of manufacturing a semiconductor device according to the first preferred embodiment, the HCD-silicon nitride film 7 is formed on the inner wall of the trench 5 as the underlying insulating film, and therefore the underlayer-dependency of the sub-atmospheric CVD can be reduced, so that the rate of film forming of the silicon oxide film within the trench 5 is improved and the film quality of the embedded insulating film 10 is also improved. This permits to embed the embedded insulating film 10 within the trench 5, without causing void and seam, thus leading to good manufacturing yield of the semiconductor device.

The end portion of the HCD-silicon nitride film 7 is formed apart from the surface of the substrate 1 by the distance d of not more than 100 nm. That is, the steps shown in FIG. 3B to FIG. 5A are performed to remove the HCD-silicon nitride film 7 formed at the region ranging from 0 nm to 100 nm from the surface of the substrate 1.

Specifically, if the HCD-silicon nitride film 7 is formed up to the substrate surface, the film 7 may also be removed to leave void between the embedded insulating film 10 and the trench 5, when the silicon nitride film 3 is removed by hot phosphoric acid in the step shown in FIG. 6A. Hence, to avoid this, the end portion of the HCD-silicon nitride film 7 is apart from the surface of the substrate 1 by the distance d of not more than 100 nm.

The semiconductor device so manufactured has a good embedded structure. This ensures sufficient electrical isolation resistance, and also realizes the semiconductor device having a high degree of reliability.

### [Second Embodiment]

FIG. 7 is a sectional view showing important parts of an embedded structure in a semiconductor device according to a second preferred embodiment. Similar components are indicated with the same reference numerals as in FIG. 1, and their descriptions are omitted herein.

In the semiconductor device shown in FIG. 7, a silicon thermal oxide film 6 is formed on the inner wall of a trench (filling portion) 5 formed in a substrate 1, and an HCD-silicon nitride film 7 is also formed as in the first preferred embodiment.

The film thickness of the HCD-silicon nitride film 7 is preferably in the range of 0.5 nm to 50 nm, for example, for the same reason as in the first preferred embodiment. The end portion of the HCD-silicon nitride film 7 is preferably apart from the surface of the substrate 1 by a distance d of not more than 100 nm, for the same reason as in the first preferred embodiment.

A first embedded insulating film 11 composed of a silicon oxide film is formed within the trench 5 via the HCD-silicon nitride film 7. The silicon oxide film that becomes the first embedded insulating film 11 is formed by the sub-atmospheric CVD method.

A second embedded insulating film 12 composed of a silicon oxide film is formed so as to fill up the trench 5, the aspect ratio of which is reduced due to the first embedded insulating film 11. The silicon oxide film that becomes the second embedded insulating film 12 is formed by the sub-atmospheric CVD method.

The embedded insulating films 11 and 12 that are embedded within the trench 5 constitute an element isolation film, and an element such as a transistor, though it is not shown, is formed at an active region of the substrate 1 surrounded by the element isolation insulating film.

In the semiconductor device having the embedded structure for element isolation, the HCD-silicon nitride film 7 formed on the inner wall of the trench 5 can improve the growth rate of the first embedded insulating film 11 filling in the interior of the trench 5, than a silicon nitride film formed by using dichlorosilane or the like. It is therefore capable of improving embeddability of the embedded insulating film 11, and attaining sufficient electrical isolation resistance, without causing voids and seams.

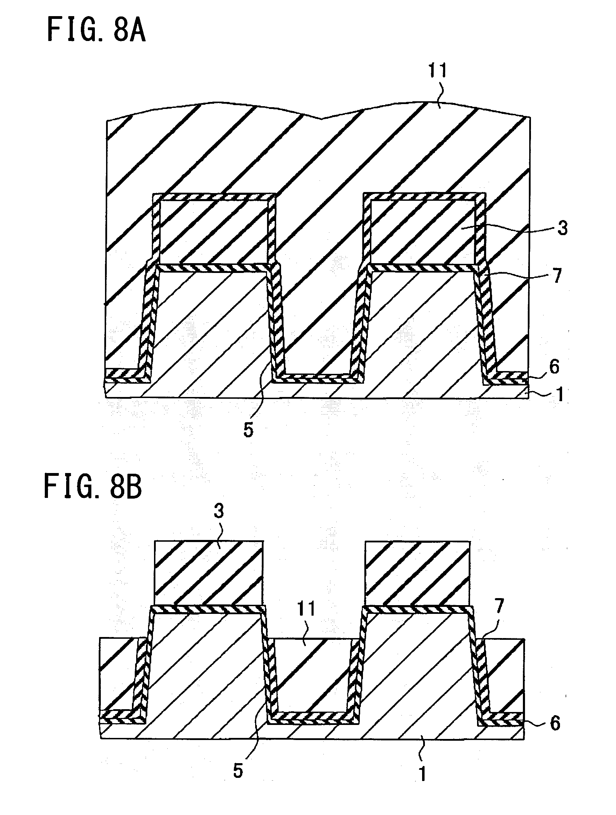

A method of manufacturing a semiconductor device according to the second preferred embodiment will next be described with reference to FIG. 8A to FIG. 9C.

After the structure shown in FIG. 3A is obtained in the same manner as in the first preferred embodiment, a first embedded insulating film 11 is formed by depositing a silicon oxide film SiO₂ so as to fill in the interior of the trench 5 by the sub-atmospheric CVD method, as shown in FIG. 8A. The forming conditions of the first embedded insulating film 11 may be the same as the sub-atmospheric CVD for forming the embedded insulating film 10 in the first preferred embodiment.

Referring to FIG. 8B, diluted hydrofluoric acid treatment is performed to selectively remove the first embedded insulating film 11 and the HCD-silicon nitride film 7. Here, the end portion of the HCD-silicon nitride film 7 is preferably apart from the surface of the substrate 1 by not more than 100 nm, as in the first preferred embodiment. The first embedded insulating film 11 relaxes a surface gap of the substrate 1 due to the trench 5.

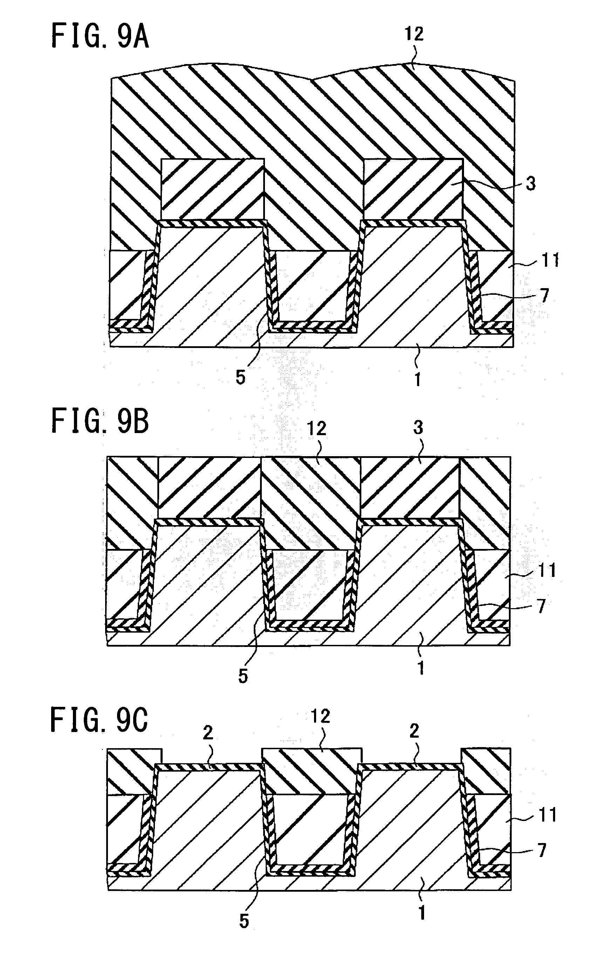

Referring to FIG. 9A, a second embedded insulating film 12 is formed by depositing a silicon oxide film SiO₂ by the sub-atmospheric CVD method, so as to cover the entire surface of the substrate 1, the surface gap of which is relaxed. The forming conditions of the second embedded insulating film 12 may be the same as the sub-atmospheric CVD for forming the embedded insulating film 10 in the first preferred embodiment.

Thereafter, annealing, for example, at 850°C for 30 minutes, is performed to make denser the embedded insulating films 11 and 12. This annealing atmosphere is preferably oxygen atmosphere (e.g., H₂O or O₂). Alternatively, the rapid thermal anneal (RTA) method may be employed.

As shown in FIG. 9B, with the silicon nitride film 3 as stopper, any excessive second embedded insulating film 12 is subjected to chemical mechanical polishing (CMP) in order to planarize the surface of the second embedded insulating film 12.

As shown in FIG. 9C, the silicon nitride film 3 is removed by the diluted hydrofluoric acid treatment and then the hot phosphoric acid treatment.

Finally, the silicon thermal oxide film 2 is removed by wet etching. This results in the embedded structure shown in FIG. 7. The semiconductor device can be manufactured through the succeeding steps of: forming a gate electrode and the like at an active region of the substrate 1; forming impurity regions that become a source or a drain by ion implantation; forming an interlayer insulating film; and forming wiring.

In the method of manufacturing a semiconductor device of the second preferred embodiment, the embeddability is first improved by forming on the inner wall of the trench 5 the HCD-silicon nitride film 7 as the underlying insulating film, and then the first embedded insulating film 11 is embedded within the trench 5 by the sub-atmospheric CVD.

In order to separate the end portion of the HCD-silicon nitride film 7 from the surface of the substrate 1 by not more than 100 nm, for the same reason as in the first preferred embodiment, the first embedded insulating film 11 covering the HCD-silicon nitride film 7 and the HCD-silicon nitride film 7 are removed. The rest of the trench 5, which is not filled with the first embedded insulating film 11, is then filled with the second embedded insulating film 12, thereby producing the embedded structure.

The method of the second preferred embodiment also enables to embed the embedded insulting films 11 and 12 within the trench 5, while preventing the occurrence of voids and seams, thus leading to good manufacturing yield of the semiconductor device.

Additionally, like the first preferred embodiment, the end portion of the HCD-silicon nitride film 7 is formed so as to apart from the surface of the substrate 1 by a distance d of not more than 100 nm. It is therefore avoidable that the HCD-silicon nitride film 7 is also etched when removing the silicon nitride film 3.

The semiconductor device so manufactured has a good embedded structure. This ensures sufficient electrical isolation resistance, and also realizes the semiconductor device having a high degree of reliability.

The present invention should not be limited to the above-mentioned preferred embodiments. While the case of embedding the insulating film within the trench 5 formed in the substrate 1 has been discussed in the foregoing, the present invention is also applicable to a case of embedding the insulating film within the recesses such as between wiring layers and between electrodes on an upper layer of the substrate. Although the embedded insulating films 10, 11 and 12 employ a silicon oxide film composed of non-doped Si glass (NSG), they may employ a silicon oxide film containing impurities such as boron and phosphorous.

Although the embedded insulating films 10, 11 and 12 are preferably formed by the sub-atmospheric CVD method, they may be formed by the high density plasma CVD (HDP-CVD) method. The HDP-CVD method is characterized by high embeddability to a fine recess pattern. Regarding to ionization density, there is used low temperature plasma of approximately 10¹¹ to 10¹²/cm³, which is increased by two digits than the usual plasma CVD.

It should be understood by those skilled in the art that various modifications, combinations, subcombinations and alterations may occur depending on design requirements and other factors insofar as they are within the scope of the appended claims or the equivalents thereof.

## Claims

1. A semiconductor device having an embedded structure in which an embedded insulating film is embedded in a filling portion formed in or on a substrate, said embedded structure comprising:
an underlying insulating film containing a silicon nitride film formed on an inner wall of said filling portion by a chemical vapor deposition method using material gas containing hexachlorodisilane, and an embedded insulating film formed by filling in said filling portion via said underlying insulating film.

2. The semiconductor device as claimed in Claim 1, wherein said embedded insulating film includes a silicon oxide film.

3. The semiconductor device as claimed in Claim 2, wherein said embedded insulating film includes a silicon oxide film formed by the sub-atmospheric CVD method.

4. The semiconductor device as claimed in Claim 1, wherein:
said filling portion includes a trench for element isolation, and
said substrate is element-isolated by an embedded structure having said underlying insulating film and said embedded insulating film.

5. A method of manufacturing a semiconductor device including a step of forming an embedded structure by embedding an embedded insulating film within a filling portion formed in or on a substrate, said method comprising:
a step of forming on an inner wall of said filling portion an underlying insulating film containing a silicon nitride film by the chemical vapor deposition method using a material gas containing hexachlorodisilane; and
a step of forming an embedded insulating film so as to fill in said filling portion via said underlying insulating film.

6. The method of manufacturing a semiconductor device as claimed in Claim 5, wherein:
said embedded insulating film including a silicon oxide film is formed in said step of forming an embedded insulating film.

7. The method of manufacturing a semiconductor device as claimed in Claim 6, wherein:
said embedded insulating film including a silicon oxide film is formed by the sub-atmospheric CVD method in said step of forming an embedded insulating film.

8. The method of manufacturing a semiconductor device as claimed in Claim 5, wherein:
said filling portion includes a trench for element isolation.
